# EUROPÄISCHE PATENTSCHRIFT

(11) **EP 3 061 156 B1**
(45) Veröffentlichungstag und Bekanntmachung des Hinweises auf die Patenterteilung: **20.03.2024**
(21) Anmeldenummer: 14761865.6
(22) Anmeldetag: 10.09.2014
(51) Int. Cl.: H01R 13/447, H01R 13/639, H01R 24/30, H01R 105/00, H01R 13/533

(54) **FELDGERÄT SOWIE VERFAHREN ZUM ANSCHLIESSEN EINER ELEKTRISCHEN ANSCHLUSSLEITUNG AN DIESEM FELDGERÄT**
FIELD DEVICE AND METHOD FOR CONNECTING AN ELECTRICAL CONNECTION TO THIS FIELD DEVICE
APPAREIL DE TERRAIN ET PROCÉDURE DE RACCORDEMENT D'UNE CONNEXION ÉLECTRIQUE À CET APPAREIL DE TERRAIN

(30) Priorität: 23.10.2013 DE 102013111696
(43) Veröffentlichungstag der Anmeldung: 31.08.2016
(60) Teilanmeldung: 24153687.9
(73) Patentinhaber: Endress+Hauser Flowtec AG, 4153 Reinach (BL) (CH)
(72) Erfinder: LARSSON, Björn, CH-4127 Birsfelden (CH); KRETZLER, Timo, 79589 Binzen (DE); UMKEHRER, Alfred, 87659 Hopferau (DE); KIRST, Michael, 79539 Lörrach (DE)
(74) Vertreter: Hahn, Christian
(86) Internationale Anmeldenummer: PCT/EP2014/069276
(87) Internationale Veröffentlichungsnummer: WO 2015/058897

(56) Entgegenhaltungen:
- EP-A1- 0 619 627
- EP-A1- 0 619 627
- DE-A1- 19 913 262
- DE-U1- 29 603 161
- GB-A- 1 580 037
- JP-A- 2007 037 220
- US-A- 3 659 248

## Beschreibung

Die Erfindung betrifft ein Feldgerät mit einer Anschlussvorrichtung. Darüberhinaus betrifft die Erfindung ein Verfahren zum Anschließen mindestens einer elektrischen Anschlußleitung an ein solches Feldgerät.

In der industriellen Prozeß-Meßtechnik werden, insb. auch im Zusammenhang mit der Automation chemischer oder verfahrenstechnischer Prozesse und/oder der automatisierten Steuerung von industriellen Anlagen, sogenannte Feldgeräte, nämlich unmittelbar an der jeweiligen Anlage installierte elektrische Meß- und/oder Schaltgeräte, wie z.B. Coriolis-Massendurchfluß-Meßgeräte, Dichte-Meßgeräte, magnetisch-induktive Durchflußmeßgeräte, Wirbel-Durchflußmeßgeräte, Ultraschall-Durchflußmeßgeräte, thermische Massendurchfluß-Meßgeräte, Druck-Meßgeräte, Füllstand-Meßgeräte, Füllstandgrenzschalter, Temperatur-Meßgeräte, ph-Wert-Meßgeräte etc., eingesetzt, die der Erzeugung von Prozeßmeßgrößen - analog oder beispielsweise auch digital - repräsentierenden Meßwerten sowie diese letztlich tragende Meßwertsignalen dienen. Bei den jeweils zu erfassenden Prozeßmeßgrößen kann es sich je nach Anwendung beispielsweise, um einen Massendurchfluß, eine Dichte, eine Viskosität, einen Füll- oder einen Grenzstand, einen Druck oder eine Temperatur oder dergleichen, eines flüssigen, pulver-, dampf- oder gasförmigen Mediums handeln, das in einem entsprechenden Behälter, wie z.B. einer Rohrleitung oder einem Tank, geführt bzw. vorgehalten wird.

Zum Erfassen der jeweiligen Prozeßmeßgröße und zum Wandeln derselben in ein damit entsprechend korrespondierendes elektrisches Meßsignal weisen Feldgeräte jeweils einen entsprechenden physikalisch-elektrischen oder chemisch-elektrischen Meßaufnehmer auf, der zumeist unmittelbar in eine Wandung des das Medium jeweils führenden Behälters oder der in den Verlauf einer das Medium jeweils führenden Leitung, beispielsweise eine Rohrleitung, eingesetzt ist. Zum Verarbeiten des Meßsignals ist der Meßaufnehmer weiters mit einer der Weiterverarbeitung oder Auswertung des wenigstens einen Meßsignals wie auch der Generierung entsprechender Meßwerte dienenden Elektronik des Feldgeräts verbunden. Die Elektronik ist typischerweise über entsprechende Anschlußleitungen an eine externe Versorgungsschaltung, beispielsweise einem Meßumformerspeisegerät, einem Speisetrenner oder einem Netzteil, bereitgestellte elektrisch angeschlossen, von der die Elektronik im Betrieb mit elektrischer Energie versorgt ist. Beispiele für derartige, dem Fachmann an und für sich bekannte Meßsysteme sind u.a. in der DE-A 199 13 262, der WO-A 88/02853, der WO-A 88/02476, der US-B 64 52 493, der US-A 2011/0317390, der EP-A 816 807, der EP-A 1 591 977 oder der US-A 2010/0101817 gezeigt bzw. werden von der Anmelderin selbst, beispielsweise unter der Bezeichnung FLOWPHANT^{®}T DTT31, t-switch ATT11, t-trend ATT12, Magphant DTI200, Promag 53H, Prowirl 73F, Promass 83X, oder Promass 84F, käuflich angeboten.

Die jeweilige Gerät-Elektronik eines solchen Feldgeräts ist zumeist in einem vergleichsweise robusten, etwa schlag-, druck-, explosions- und/oder wetterfesten, Elektronik-Gehäuse untergebracht. Dieses kann z.B. vom Feldgerät entfernt angeordnet und mit diesem nur über eine flexible Leitung verbunden sein; es kann aber auch direkt am Meßaufnehmer oder an einem den Meßaufnehmer separat einhausenden Meßaufnehmer-Gehäuse angeordnet sein. Zur Anzeige von Meßwerten vor Ort weisen solche Elektroniken ferner zumeist auch ein in nämlichem Elektronik-Gehäuse plaziertes, beispielsweise mittels eines LCD-Displays gebildetes, Anzeigelement auf, das in modernen Feldgeräten beispielsweise auch mittels einer, ggf. auch herausnehmbare, kombinierte Anzeige-/Bedieneinheit gebildet sein kann.

Bei einer Vielzahl von in der industriellen Meßtechnik verwendeten Feldgeräten mit Meßaufnehmer wird dieser zum Erzeugen des Meßsignals im Betrieb zudem von einem von der Betriebs- und Auswerteschaltung zumindest zeitweise generierten Treibersignal so angesteuert, daß nämlicher Meßaufnehmer in einer für die Messung geeigneten Weise zumindest mittelbar oder aber auch über eine das Medium direkt kontaktierende Sonde praktisch unmittelbar auf das Medium einwirkt, um dort mit der jeweils zu erfassenden Prozeßmeßgröße entsprechend korrespondierende und auf den Meßaufnehmer rückwirkende Reaktionen hervorzurufen. Das Treibersignal kann dabei beispielsweise hinsichtlich einer Stromstärke, einer Spannungshöhe und/oder einer Frequenz entsprechend geregelt sein. Als Beispiele für solche aktiven, also ein elektrisches Treibersignal im Medium entsprechend umsetzende Meßaufnehmer sind im besonderen dem Messen von zumindest zeitweise strömenden Medien dienende Durchfluß-Meßaufnehmer, z.B. mit wenigstens einer vom Treibersignal angesteuerten, Magnetfeld erzeugenden Spule oder wenigstens einem vom Treibersignal angesteuerten Ultraschallsender, oder aber auch dem Messen und/oder Überwachen von Füllständen in einem Behälter dienende Füllstands- und/oder Grenzstandsaufnehmer, wie z.B. mit freistrahlender Mikrowellenantenne, mit Gouboun-Leitung oder mit vibrierendem Tauchkörper, zu nennen.

Die von der Gerät-Elektronik generierten Meßwerte werden typischerweise an entsprechenden Schaltungsausgängen inform von elektrischen - digitalen oder analogen - Meßwertsignalen bereitgestellt, beispielsweise inform eines im Bereich von 4 - 20 mA entsprechend modulierten analogen Signalstroms. Darüberhinaus sind auch sogenannte Frequenzausgänge, nämlich die Meßwerte in eine Pulsfolgefrequenz eines binären Rechtecksignals codierende Schaltungsausgänge, oder auch sogenannte Impulsausgänge, nämlich das Erreichen einer vorab wählbaren, quantisierten Mengeneinheit inform eines Impulses signalisierende Schaltungsausgänge, zur Bereitstellung von Meßwerten üblich. Neben vornehmlich dem Erfassen einer physikalischen Meßgröße dienenden Feldgeräten mit jeweils einem Meßaufnehmer gibt es zudem auch solche, beispielsweise als elektro-motorische Stellventile oder Pumpen ausgebildete, Feldgeräte die im besonderen dafür vorgesehen sind, eine oder mehrere physikalische Prozeßparameter einzustellen, mithin aktiv in den jeweiligen Prozeß einzugreifen, zusätzlich aber auch interne Meß- und/oder Einstellwerte an entsprechenden Schaltungsausgängen zur Verfügung stellen. Neben Meßwerte bereitstellenden Schaltungsausgängen der vorgenannten Art kann die Gerät-Elektronik eines modernen Feldgeräts gelegentlich auch sogenannte Status- bzw. Alarmausgänge und/oder auch dem unmittelbaren Ansteuern von an das jeweilige Feldgerät direkt angeschlossenen externen elektrischen Geräten, mithin als Relais dienende Schaltausgänge aufweisen. Solche Schaltungsausgänge können als passiver, nämlich in einen von einer extern des Feldgeräts stationierten Spannungsquelle getriebenen Stromkreis eingeschleifter Schaltungsausgang oder auch als ein in einen von einer Feldgeräte internen Spannungsquelle getriebenen Stromkreis eingeschleifter aktiver Schaltungsausgang realisiert sein. Alternativ oder in Ergänzung könne Feldgeräte auch Schaltungsausgänge zum Anschließen eines, beispielsweise seriellen, Feldbusses aufweisen.

Zum Verbinden von internen, nämlich innerhalb des Elektronik-Gehäuses untergebrachten elektrischen bzw. elektronischen Schaltungen, nicht zuletzt auch von Schaltungsausgängen der eingangs erwähnten Art, mit einer oder mehrerer externer elektrischer Schaltungen, beispielsweise auch der erwähnten externen Versorgungsschaltung, weisen Feldgeräte jeweils eine Anschlußvorrichtung zum elektrischen Anschließen einer dem Feldgerät von extern zugeführten, mithin zumindest teilweise extern des jeweiligen Elektronik-Gehäuses verlegten, zwei oder mehradrigen, Anschlußleitung auf. Solche Anschlußvorrichtungen von Feldgeräten sind zuweilen mittels eines Steckverbinders gebildet, von dem eine erstes Steckverbinderteil an die jeweilige Schaltung des Feldgeräts elektrisch angeschlossen und zugleich an einem innerhalb des Elektronik-Gehäuses plazierten Grundkörper, beispielsweise einem Elektronikeinsatz oder einer Leiterplatte, fixiert ist, und von dem ein zum ersten Steckverbinderteil komplementäres zweites Steckverbinderteil mit der Anschlußleitung verbundenen ist. Im Betrieb des jeweiligen Feldgeräts sind nämliche Steckverbinderteile unter Bildung eines von der Anschlußleitung zur Gerät-Elektronik führenden elektrischen Strompfades fest, gleichwohl wieder lösbar miteinander verbunden. Bei Steckverbindern der in Rede stehenden Art sind das erste Steckverbinderteil zumeist als Einbaustecker und das zweite Steckverbinderteil entsprechend als Kupplung ausgebildet, derart, daß das erste Steckverbinderteil wenigstens einen an die Schaltung des Feldgeräts elektrisch angeschlossenen Kontaktstift und das zweite Steckverbinderteil wenigstens eine mit zumindest einer Ader der Anschlußleitung elektrisch verbundenen Kontakthülse aufweisen, und daß die beiden Steckverbinderteile so miteinander verbunden sind, daß die wenigstens eine Kontakthülse des zweiten Steckverbinderteils auf den wenigstens einen Kontaktstift des ersten Steckverbinderteils unter Bildung einer als Reibschluß ausgebildeten mechanischen Verbindung aufgesteckt ist und zugleich nämlichen Kontaktstift - infolge einer zwischen Kontakthülse und Kontaktstift erzeugten Flächenpressung - unter Bildung einer als Steckkontakt ausgebildeten elektrischen Verbindung elektrisch gut leitend kontaktiert. Durch die Verwendung von solchen Steckverbindern ist das elektrische Anschließen des jeweiligen Feldgeräts an externe elektrische Schaltungen bzw. die jeweiligen Anschlußleitungen erheblich vereinfacht und kann zugleich die Fehleranfälligkeit des mittels des jeweiligen Steckverbinders typischerweise nämlich erst vor Ort fertiggestellten elektrischen Strompfades sehr gering gehalten werden, beispielsweise auch durch Ausgestalten des Steckverbinders nach dem bekannten Poka-Yoke-Prinzip. Umgekehrt kann ein mittels eines solchen Steckverbinders gebildeter elektrischer Strompfad auch sehr rasch dadurch wieder unterbrochen werden, daß die wenigstens eine Kontakthülse des zweiten Steckverbinderteils vom Kontaktstift des ersten Steckverbinderteils entlang einer vorgegebenen Auszugsbahn abgezogen wird, indem das zweite Steckverbinderteil unter Aufbietung einer in einer Richtung der Auszugsbahn wirkenden Abzugskraft vom ersten Steckverbinderteil getrennt wird.

Ein Nachteil solcher Steckverbinder ist allerdings darin zu sehen, daß diese, nicht zuletzt bedingt auch durch ihre Funktion, zumeist selbst nur sehr geringe Haltekräfte entwickeln, bzw. daß umgekehrt bereits eine geringe auf das zweite Steckverbinderteil wirkende Abzugskraft ein Abtrennen des zweiten Steckverbinderteils vom ersten Steckverbinderteil bewirken kann. Dies kann beispielsweise auch dazu führen, daß solche Steckverbinder sich durch allfällige, etwa durch vom jeweiligen Behälter auf das Feldgerät übertragene Rüttelbewegungen verursachte, Vibrationen des Elektronik-Gehäuses selbstätig lösen können, einhergehend mit einem plötzlichen Versagen des Feldgeräts aufgrund unterbrochener elektrischer Strompfade. Es existieren daher auch entsprechende, beispielsweise auch zu einem der etablierten Standards C22.2 No 213-M1987, ANSI/ISA-12.12.01-2010, FM3611-2004 bzw. IEC 60079-15:2010 konforme Vorgaben zur Gerätesicherheit solcher Anschlußvorrichtungen von Feldgeräten, wonach in einem Feldgerät zum Trennen beider Steckverbinderteile eines Steckverbinders der in Rede stehenden Art eine Abzugskraft von mindestens 15 N (Newton) aufgeboten werden muss bzw. umgekehrt mit weniger als 15 N auf das zweite Steckverbinderteil wirkende Abzugskräfte kein Trennnen des Steckverbinders, mithin kein Abziehen der Kontakthülse des zweiten Steckverbinderteils vom wenigstens einen Kontaktstift des ersten Steckverbinderteils bewirken dürfen. Darüberhinaus können aber auch von solchen Steckverbindern anfänglich zunächst in ausreichender Höhe aufgebrachte Haltekräfte im Lauf der Zeit, nicht zuletzt infolge von Materialermüdungen, allmählich abnehmen.

Dem Rechnung tragend besteht eine Aufgabe der Erfindung darin, ein Feldgerät mit einer Anschlussvorrichtung bereit zu stellen, bei der zum einen ein selbsttätiges Lösen des Steckverbinders im Betrieb des Feldgeräts - etwa derart, daß dessen zweiter Steckverbinderteil ungewollt vom ersten

Steckverbinderteil getrennt würde - sicher verhindert ist, und bei der zum anderen der Steckverbinder zwecks eines Verbindens von Anschlußleitung und Elektronik einfach hantiert bzw. zwecks eines Trennens von Anschlußleitung und Gerät-Elektronik auf einfache Weise und unter Aufbietung möglichst geringer Abzugskräfte wieder gelöst werden kann.

Zur Lösung der Aufgabe besteht die Erfindung in einem, beispielsweise als Meß- und/oder Schaltgerät ausgebildeten, Feldgerät, gemäß dem unabhängigen Anspruch 1.

Ferner besteht die Erfindung auch in einem Verfahren gemäß Anspruch 13 zum Anschließen mindestens einer elektrischen Anschlußleitung an nämliches Feldgerät.

Bei einem erfindungsgemäßen Feldgerät wird ein in ein erstes Verbindungssteckerteil unter Bildung eines Steckverbinders eingestecktes zweites Verbindungssteckerteil zusätzlich mit Hilfe einer verschwenkbaren Abdeckklappe fixiert. Die Innenseite der Abdeckklappe ist so geformt, dass sie den Verbindungsstecker in seiner eingesteckten Position zusätzlich fixiert. Bei geschlossener Abdeckklappe wird ein unbeabsichtigtes Abziehen des Verbindungssteckers verhindert. Bei geschlossener Abdeckklappe kann das zweite Steckverbinderteil allenfalls mit großem Kraftaufwand, nämlich nur mit einer mehr als 15 N (Newton) betragenden Abzugskraft bzw. nur durch Zerstören der Anschlußvorrichtung vom ersten Steckverbinderteil abgezogen werden. Anforderungen der Gerätesicherheit, wonach zum Abziehen des zweiten Steckverbinderteils vom ersten Steckverbinderteil eine Abzugskraft von mindestens 15 N (Newton) erforderlich sein muß, können mit Hilfe der verschwenkbaren Abdeckklappe somit auf sehr einfache, gleichwohl sehr effektive Weise erfüllt werden. Die Abdeckklappe ermöglicht eine zusätzliche Fixation des mit dem ersten Steckverbinderteil verbundenen zweiten Steckverbinderteils in der so erzielten Einbaulage. Die Abdeckklappe kann zudem dafür eingerichtet sein, das erste Steckverbinderteil und das aufgesteckten zweite Steckverbinderteil zumindest teilweise abzudecken, so dass ein zusätzlicher Berührungsschutz geschaffen ist, derart daß ein Benutzer am unbeabsichtigten Berühren des Steckverbinders, nicht zuletzt auch von dessen spannungsführenden Bereichen, gehindert wird.

Die Erfindung sowie weitere vorteilhafte Ausgestaltungen davon werden nachfolgend anhand von Ausführungsbeispielen näher erläutert, die in den Figuren der Zeichnung dargestellt sind. Gleiche Teile sind in allen Figuren mit denselben Bezugszeichen versehen; wenn es die Übersichtlichkeit erfordert oder es anderweitig sinnvoll erscheint, wird auf bereits erwähnte Bezugszeichen in nachfolgenden Figuren verzichtet. Weitere vorteilhafte Ausgestaltungen oder Weiterbildungen, insb. auch Kombinationen zunächst nur einzeln erläuterter Teilaspekte der Erfindung, ergeben sich ferner aus den Figuren der Zeichnung wie auch den Unteransprüchen an sich. Im einzelnen zeigen:
- Fig. 1a: schematisch in einer perspektivischen Seitenansicht ein mittels eines in den Verlauf einer Rohrleitung eingesetzten Meßaufnehmers und einer mit diesem elektrische verbundenen Gerät-Elektronik gebildetes Feldgerät;
- Fig. 1b: schematisch in einer perspektivischen Seitenansicht ein für ein Feldgerät gemäß Fig. 1 geeignetes Elektronik-Gehäuse;
- Fig. 2a, 2b, 3a, 3b, 3c: jeweils schematisch in einer perspektivischen Seitenansicht eine für ein Feldgerät gemäß Fig. 1 geeignete Gerät-Elektronik sowie eine damit elektrisch verbundene Anschlußvorrichtung zum elektrischen Verbinden einer Anschlußleitung mit einer Schaltung nämlicher Gerät-Elektronik;
- Fig. 4: in einer Schnittdarstellung eine Abdeckklappe der in Fig. 2a, 2b, 3a, 3b, bzw. 3c jeweils gezeigten Anschlußvorrichtung;
- Fig. 5a, 5b: jeweils schematisch in einer teilweise geschnittenen perspektivischen Seitenansicht eine für ein Feldgerät gemäß Fig. 1 geeignete Gerät-Elektronik sowie eine damit elektrisch verbundene Anschlußvorrichtung zum elektrischen Verbinden einer Anschlußleitung mit einer Schaltung nämlicher Gerät-Elektronik; sowie
- Fig. 6: in einer geschnittenen perspektivischen Seitenansicht ein für ein Feldgerät gemäß Fig. 1b geeignetes Elektronik-Gehäuse mit darin untergebrachter Anschlußvorrichtung.

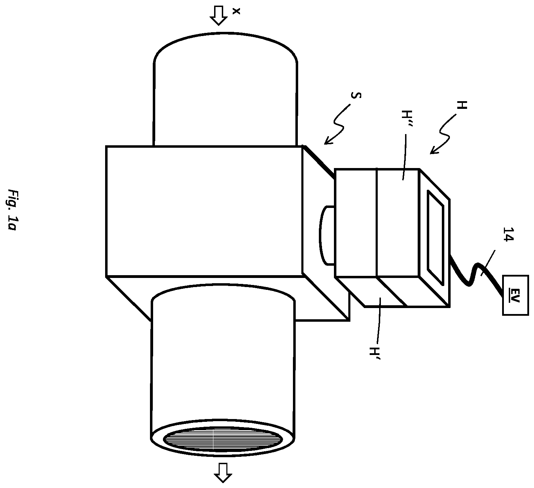

Fig. 1a zeigt den prinzipiellen Aufbau eines - beispielsweise als Messgerät für die Durchflussmessung ausgebildeten - Feldgeräts. Das Feldgerät kann_wie in Fig. 1a angedeutet - z.B. zur Bestimmung einer Meßgröße x eines in einer - hier nicht gezeigten - Rohrleitung strömenden Mediums, beispielsweise einer Flüssigkeit oder einer fließfähigen Dispersion, dienen. Dafür weist das Feldgerät einen Meßaufnehmer S zum Erzeugen wenigstens eines von der zu erfassenden Meßgröße x abhängigen Meßsignals auf, der im in Fig. 1a gezeigten Ausführungsbeispiel mittels eines in den Verlauf nämlicher Rohrleitung einsetzbaren, mithin im Betrieb vom in der Rohrleitung jeweils geführten Medium durchströmten Meßrohrs gebildet ist. Bei dem Feldgerät kann es sich demnach beispielsweise auch um ein zur Messung einer Volumendurchflußrate geeignetes magnetisch-induktives Durchfluß-Meßgerät (MID) handeln. Bei einem derartigen Durchfluß-Meßgerät erfolgt die Messung der Volumendurchflußrate bekanntermaßen basierend auf einer mittels eines das Meßrohr, mithin das darin strömende Medium senkrecht zur Strömungsrichtung durchsetzenden Magnetfelds induzierten, als Meßsignal dienenden Meßspannung, die eine von einer momentanen Strömungsgeschwindigkeit des Mediums bzw. der daraus abgeleiteten Voulmendurchflußrate abhängige Spannungshöhe aufweist und die mittels zweier im Meßaufnehmer vorgesehenen Elektroden abgegriffen wird.

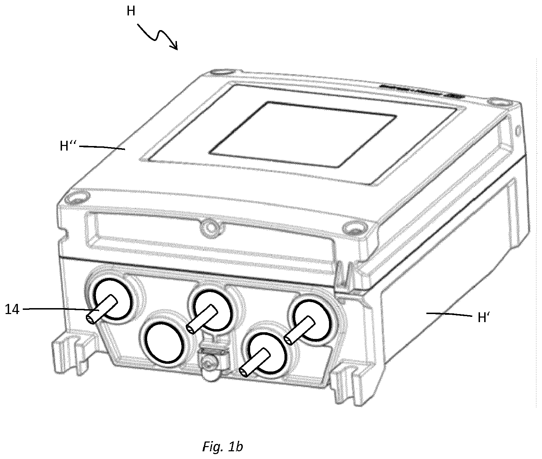

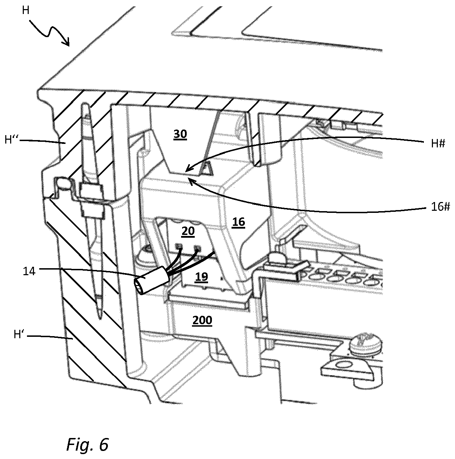

Zur Verarbeitung des wenigstens einen von der jeweils zu ermittelnden Meßgröße abhängigen Meßsignals, beispielsweise also der vorbezeichneten Meßspannung, nicht zuletzt auch zur Wandlung nämlichen Meßsignals in entsprechende Meßwerte, beispielsweise also für die Volumendurchflußrate, umfaßt das Feldgerät eine in einem Elektronik-Gehäuse H untergebrachte Gerät-Elektronik, die an den Meßaufnehmer S entsprechend elektrisch angeschlossen ist. Das Elektronik-Gehäuse H weist einen Gehäuse-Grundkörper H` sowie einen diesen verschließenden Gehäuse-Deckel H" auf. Der Gehäuse-Grundkörper H` kann, wie bei Elektronik-Gehäusen für Feldgeräte durchaus üblich, beispielsweise topfförmig oder, wie aus einer Zusammenschau der Fig. 1a, 1b und 6 ersichtlich, beispielsweise auch eher kastenförmig ausgebildet sein. Der Gehäuse-Grundkörper H` und/oder der Gehäuse-Deckel H" können desweiteren beispielsweise jeweils ein aus einem Metall, beispielsweise einem Stahl oder einer Aluminium-Legierung, hergestelltes Formteil sein. Der Gehäuse-Grundkörper H` und/oder der Gehäuse-Deckel H" können beispielsweise aber auch jeweils zumindest anteilig oder gänzlich aus einem Kunststoff bestehen. Gehäuse-Grundkörper H` und Gehäuse-Deckel H" können zudem jeweils mittels eines dem jeweils verwendeten Material entsprechend angepaßtes Urformverfahren, beispielsweise durch Gießen, Druckgießen oder Spritzgießen, gefertigt sein. Der- beispielsweise auch aus demselben Material, wie der Gehäuse-Grundköper hersgestellte - Gehäuse-Deckel H" kann - wie auch in Fig. 1b angedeutet - mittels zwei oder mehr, beispielsweise nämlich vier Schraubverbindungen wieder lösbar am Gehäuse-Grundkörper H` fixiert sein.

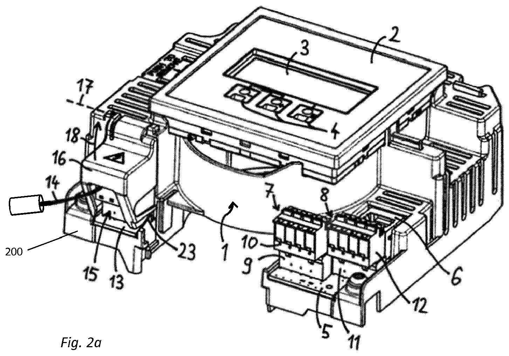

Zur weiteren Verarbeitung des jeweiligen Meßsignals umfasst die hier gezeigte Gerät-Elektronik einen zentral angeordneten Messverstärker 1. Der Messverstärker 1 kann beispielsweise mittels einer Instrumentenverstärker-Schaltung gebildet und zudem dafür eingerichtet sein, das wenigstens eine Meßsignal, beispielsweise nämlich die erwähnte Meßspannung, weitgehend rückwirkungsfrei zu erfassen und hernach zu verstärken. Oberhalb des Messverstärkers 1 ist ferner eine Anzeige-Bedieneinheit 2 angebracht, die ein beispielsweise als LCD-Display ausgebildetes Anzeigelement 3 sowie ein mittels optischer Eingabetasten gebildetes Bedienelement 4 umfasst. Mittels des Anzeigelements 3 können beispielsweise ein aktuell gemessener Meßwert für die Meßgröße, hier beispielsweise die Volumendurchflußrate, und/oder Einstellwerte verschiedener Betriebsparameter des Feldgeräts angezeigt werden. Mit Hilfe des Bedienelements 4 kann eine Bedienperson entsprechende Eingaben zur Steueerung und/oder Programmierung der Gerät-Elektronik vornehmen. Der jeweils ermittelte Meßwert kann zudem beispielsweise auch über einen Feldbus an einen zentralen Steuerrechner oder eine speicherprogrammierbare Steuerung (SPS) übermittelt werden. Hierzu ist in der Gerät-Elektronik eine IO-Platine 5, nämliche eine auf einer Leiterplatte aufgebaute Ein-/Ausgangsschaltung, vorgesehen, mit der die Gerät-Elektronik, mithin das damit gebildete Feldgerät an einen Feldbus angeschlossen werden kann. Die IO-Platine 5 ist dazu ausgelegt, Messwerte in ein für den Feldbus geeignetes, nämlich einem jeweiligen Feldbusprotokoll entsprechendes Datentelegramm umzusetzen. Es werden unterschiedliche Typen von IO-Platinen angeboten, welche unterschiedliche Feldbusprotokolle wie beispielsweise HART, Profibus, Modbus, Ethernet IP etc. unterstützen. Die in den Fig. 2a, 3a bzw. 4a exemplarisch gezeigte IO-Platine 5 weist beispielsweise einen Ethernet-Stecker 6 sowie zwei jeweils vierpolige Kupplungverbindungen 7, 8 auf, über die die Gerät-Elektronik, mithin das damit gebildete Feldgerät beispielsweise an einen seriellen Feldbus angeschlossen werden kann. Die erste vierpolige Kupplungverbindung 7 umfasst einen auf der IO-Platine 5 montierten Einbaustecker 9, in den ein zugehöriger Verbindungsstecker 10 einsteckbar ist. Die zweite vierpolige Kupplungverbindung 8 umfasst ebenfalls einen auf der IO-Platine 5 montierten Einbausteck 11, in den ein zugehöriger Verbindungsstecker 12 einsteckbar ist. Die beiden vierpoligen Verbindungsstecker 10, 11 sind jeweils mit vier Federklemmen zum Anschluss einzelner Adern von entsprechenden Verbindungskabeln ausgestattet.

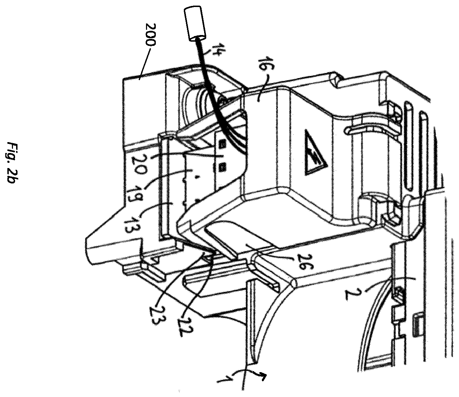

Die in Fig. 2 a, 3a bzw. 4a jeweils gezeigte Gerät-Elektronik umfasst darüber hinaus eine Netzplatine 13, nämlich eine auf einer Leiterplatte aufgebaute, als Netzteil ausgebildete Schaltung der Gerät-Elektronik bzw. des damit gebildeten Feldgeräts, die mit einer von einer externen, vom Feldgerät entfernten Versorgungsschaltung EV, beispielsweise einem Meßumformerspeisegerät, einem Speisetrenner oder einem Wechselstrom-Netzteil, bereitgestellten Versorgungsspannung betrieben wird. Die - im hier gezeigten Ausführungsbeispiel neben dem Messverstärker 1 angeordnete - Netzplatine 13 ist dafür eingerichtet, die verschiedenen von der Gerät-Elektronik bzw. dem damit gebildeten Feldgerät im Betrieb benötigten Betriebsspannungen, beispielsweise mit einer Spannungshöhe von unter 20 V (Volt) bereitstellen. Im hier gezeigten Ausführungsbeispiel ist die Netzplatine 13 bzw. die damit gebildete Gerät-Elektronik dafür eingerichtet, mit Netzspannung, beispielsweise also mit 230 V~ 60 Hz (Hertz), als Versorgungsspannung betrieben zu werden.

Die Versorgungsspannung wird der Netzplatine 13 über eine - beispielsweise mittels eines zwei- oder mehradrigen Kabels gebildete - an die Versorgungsschaltung EV elektrisch angeschlossenes, mithin teilwiese extern des Elektronik-Gehäuses des Feldgeräts verlegte Anschlußleitung 14 und weiter über einen im Betrieb daran elektrisch angeschlossene Anschlußvorrichtung zugeführt. Zum elektrischen Verbinden nämlicher Anschlußleitung 14 mit der Netzplatine 13 umfaßt die Anschlußvorrichtung einen, insb. zumindest anteilig aus einem elektrisch isolierenden Kunststoff bestehenden und/oder als die Gerät-Elektronik zumindest teilweise kapselnden Elektronikeinsatz ausgebildeten, Grundkörper 200 sowie einen daran gehalterten Steckverbinder 15. Der Steckverbinder 15 umfaßt ein am Grundkörper 200 fixierten und zugleich an die Netzplatine 13 elektrisch angeschlossenen erstes Steckverbinderteil 19 sowie ein mit der Anschlußleitung 14 verbindbaren bzw. im Betrieb verbundenen, zum ersten Steckverbinderteil 19 komplementäres zweites Steckverbinderteil 20.

Das Steckverbinderteil 19 weist wenigstens einen an die Schaltung des Feldgeräts elektrisch angeschlossenen Kontaktstift 19' auf, während das Steckverbinderteil 20 wenigstens eine - hier nämlich mit zumindest einer Ader der Anschlußleitung 14 elektrisch verbindbare bzw. im Betrieb verbundene Kontakthülse 20' umfaßt. Darüberhinaus sind das Steckverbinderteil 19 und das Steckverbinderteil 20 - wie auch aus einer Zusammenschau der Fig. 2a, 2b, 3a, 3b, 3c, 4a, 4b und 6 ohne weiteres ersichtlich - wieder lösbar miteinander verbunden; dies im besonderen in der Weise, daß die wenigstens eine Kontakthülse 20' des Steckverbinderteils 20 auf den wenigstens einen Kontaktstift 19' des Steckverbinderteils 19 unter Bildung eines Reibschlusses aufgesteckt ist und diesen elektrisch leitend kontaktiert. Das Steckverbinderteil 19 kann -wie schematisch dargestelltdemnach beispielsweise auch als Einbaustecker ausgebildet sein, während das Steckverbinderteil 20 beispielsweise eine Kupplung sein kann.

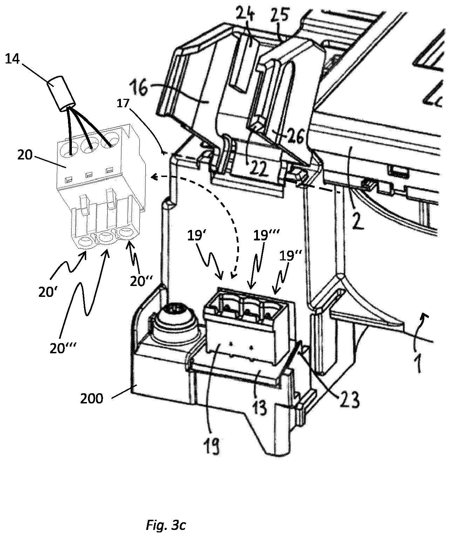

Nachdem im hier gezeigten Ausführungsbeispiel die mittels der Anschlußvorrichtung anzuschließende Anschlußleitung 14 dem Zuführen der Versorgungsspannung dient, weisen, wie auch in Fig. 3c angedeutete, das Steckverbinderteil 19 zusätzlich zum Kontaktstift 19' wenigstens einen weiteren - zweite - Kontaktstift 19" und das Steckverbinderteil 20 zusätzlich zur Kontakthülse 20' wenigstens eine weitere - zweite - Kontakthülse 20" auf. Bei einer Versorgung der Gerät-Elektronik mit Netzspannung können so beispielsweise nämlich der Außenleiter (L) an die Kontakthülse 20' und der Neutralleiter (N) an die zusätzliche Kontakthülse 20" angeschlossen und somit über den entsprechend an den jeweils korrespondierenden Kontaktstift 19' bzw. 19"weiter der Netzplatine 13 zugeführt werden. Zusätzlich kann zudem auch der ggf. vorgesehene Schutzleiter (PE) über den Steckverbinder 15 - nämlich über eine weitere - dritte - Kontakthülse 20‴ sowie einen entsprechend korrespondierenden - dritten - Kontaktstift 19‴ mit der Netzplatine 13 verbunden werden. Alternativ oder in Ergänzung kann der Schutzleiter (PE) beispielsweise auch an ein - hier nicht gezeigte - Erdungsblech angeschlossen werden.

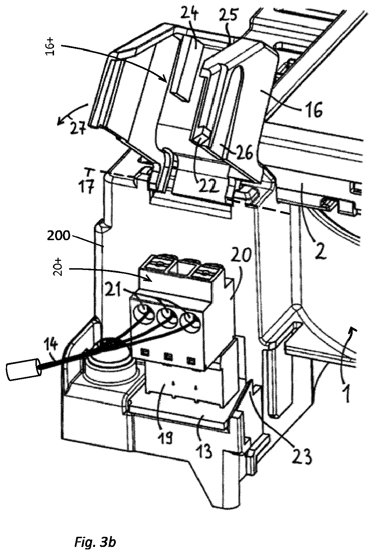

Zum Anschließen der Anschlußleitung 14 an das, beispielsweise als Kupplung ausgebildete, Steckverbinderteil 20 kann dieses ferner z.B. entsprechende - beispielsweise also zwei oder drei - Federklemmelemente 21 aufweisen, von denen jede jeweils mit einer der Kontakthülsen 20', 20" bzw. 20‴ elektrisch verbunden ist und in denen die einzelnen - beispielsweise als Litzen bzw. als massive Drähte ausgebildeten - Adern der Anschlußleitung 14 festgeklemmt sind. Das Steckverbinderteil 20 umfasst in dem in Fig. 3b gezeigten Ausführungsbeispiel demnach genau drei Federklemmelemente 21 zum Festklemmen der einzelnen Adern des Anschlusskabels 14. Hierbei kann das Anschlusskabel 14 beispielsweise aber auch als nur zweiadriges Anschlusskabel ausgelegt sein, von dem eine erste Ader für den Außenleiter (L) in an die erste Kontakthülse 20' und eine zweite Ader für den Neutralleiter (N) an die Kontakthülse 20" angeschlossen ist, derart, das die gleichfalls vorhandene - mittlere - Kontakthülse 20‴ freigelassen bleibt. Alternativ dazu kann das Anschlusskabel 14 aber beispielsweise auch als ein dreiadriges Kabel ausgelegt sein, welches zusätzlich zu den Adern für den Außenleiter und den Neutralleiter eine mit der Kontakthülse 20‴ verbundene dritte Ader für den Schutzleiter (PE) umfasst.

Für Steckverbinder der in Rede stehenden Art wird regelmäßig gefordert, daß zum Trennen eines solchen Steckverbinders, hier nämlich zum Abziehen des Steckverbinderteils 20 vom Steckverbinderteil 19 bzw. zum Abziehen der wenigstens einen Kontakthülse 20' vom wenigstens einen korrespondierenden Kontaktstift 19' eine Abzugskraft von mindestens 15 N (Newton) aufgeboten werden muß, bzw. daß eine mit weniger als 15 N auf das zweite Steckverbinderteil 20 wirkende Abzugskraft kein Abziehen nämlichen Steckverbinderteils 20 vom Steckverbinderteil 19, mithin kein Abziehen der Kontakthülse 20' vom Kontaktstift 19' bewirkt. Durch eine solche Anforderung soll ein allzu leichtes, ggf. auch selbsttätiges Lösen des Steckverbinderteil 20 vom Steckverbinderteil 19, mithin ein unbeabsichtigtes Auftrennen Steckverbinders 15 während des Betriebs des Feldgeräts verhindert werden. Zudem darf das Steckverbinderteil 20 auch nicht versehentlich abgezogen werden können, da dies nicht zuletzt in unmittelbarer Nachbarschaft zu einer elektrisch leitfähigen Flüssigkeit, ein erhöhtes Sicherheitsrisiko darstellen kann.

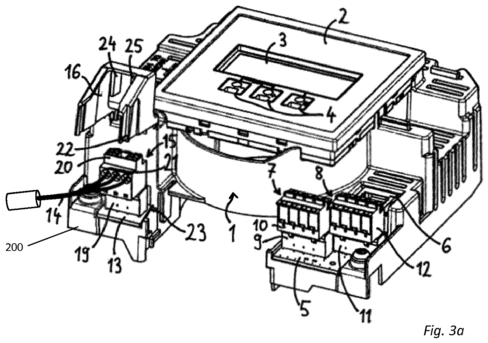

Um diese Anforderung aus der Gerätesicherheit zu erfüllen bzw. sicherzustellen, dass zum Abziehen des Steckverbinderteils 20 eine Abzugskraft von mindestens 15 N erforderlich ist, weist die erfindungsgemäße Anschlußvorrichtung, wie auch aus den Fig. 2a, 2b, 3a, 3b, und 3c bzw. deren Zusammenschau jeweils ersichtlich, ferner eine am Grundkörper 200 beweglich - hier nämlich um eine Achse 17 verschwenkbar - gehalterte, beispielsweise zumindest anteilig aus einem elektrisch isolierenden Kunststoff bestehende, Abdeckklappe 16 zum zumindest teilweisen Abdecken des Steckverbinders 15 auf.

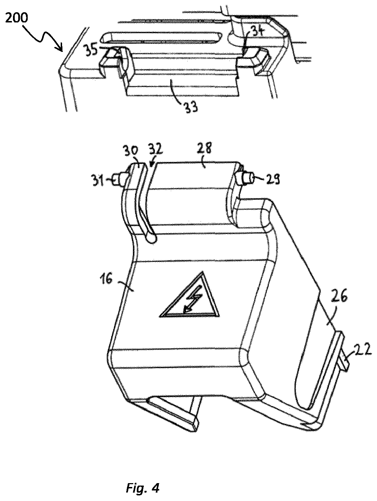

In Fig. 4 sind die Abdeckklappe 16 sowie das am Grundkörper 200 entsprechend zur Aufnahme der Achse 17 bzw. zum verschwenkbaren Haltern der Abdeckklappe 16 vorgesehene Lager nochmals vergrößert dargestellt. Die Abdeckklappe 16 kann - wie bereits angedeutet - beispielsweise als eine Kunststoffformteil ausgebildet sein. Zur schwenkbaren Lagerung der Abdeckklappe 16 weist diese einen ersten Halterungsabschnitt 28 mit einem ersten Achszapfen 29 sowie einen zweiten Halterungsabschnitt 30 mit einem zweiten Achszapfen 31 auf. Zwischen dem - hier rechten - Halterungsabschnitt 28 und dem - hier linken - Halterungsabschnitt 30 befindet sich ein Spalt 32. Der Halterungsabschnitt 30 ist wesentlich schmaler ausgebildet als der Halterungsabschnitt 28 und kann daher aufgrund des Spaltes 32 in gewissem Maß federnd verformt werden. Wie ferner aus der Fig. 4 ersichtlich umfaßt das hier gezeigte Lager für die Abdeckklappe 16 eine Aussparung 33, eine erste Aufnahme 34 für den Achszapfen 29 sowie eine zweite Aufnahme 35 für den Achszapfen 31. Zum Einfügen der Abdeckklappe 16 in das Lager kann der Halterungsabschnitt 30 elastisch verformt werden, so dass die beiden Achszapfen 29, 31 in die entsprechenden Aufnahmen 34, 35 einpaßbar und hernach durch Entlassen des Halterungsabschnitt 30 in seine Ausgangsform in den Aufnahmen 34, 35 drehbar gelagert sind.

Die Abdeckklappe 16 ist - wie aus einer Zusammenschau der Fig. 2a bzw. 2b sowie 3a bzw. 3b ohne weiteres ersichtlich - zwischen einer ersten Endlage, in der die Abdeckklappe 16 den Steckverbinder zumindest teilweise abdeckt (Fig. 2a; Fig. 2b), und einer zweiten Endlage (Fig. 3a; Fig. 3b) verschwenkbar. Im hier gezeigten Ausführungsbeispiel kann die Abdeckklappe 16 beispielsweise um die Achse 17 in Richtung des Pfeils 18 - in Fig. 2a bzw. 2b nämlich nach oben - bzw. wieder zurück - in Fig. 3a bzw. 3b nämlich nach unten - geschwenkt werden und so aus der in Fig. 2a bzw. 2b jeweils gezeigten ersten Endlage in eine geöffnete Position - beispielsweise nämlich in die zweite Endlage - verbracht werden.

Die Abdeckklappe 16 der erfindungsgemäßen Anschlußvorrichtung ist im besonderen ferner dafür eingerichtet, in zumindest eine zwischen der ersten Endlage und der zweiten Endlage befindlichen Öffnungsstellung verschwenkt werden zu können und in nämlicher - ggf. auch mit der zweiten Endlage koinzidenten - Öffnungsstellung den Steckverbinder 15 soweit freizugegeben, daß die wenigstens eine Kontakthülse 20' des zweiten Steckverbinderteils 20 vom wenigstens einen Kontaktstift 19' des ersten Steckverbinderteils 19 entlang einer vorgegebenen Abzugsbahn abziehbar ist, indem das zweite Steckverbinderteil 20 - wie auch in Fig. 3c angedeutet, unter Aufbietung einer in einer Richtung der Abzugsbahn wirkenden Abzugskraft, vom ersten Steckverbinderteil 19 getrennt wird. Nach einer weiteren Ausgestaltung ist die Abdeckklappe 16 - nicht zuletzt zum Schutz einer Bedienperson vor versehentlichem Kontakt mit der, ggf. auch oberhalb einer zulässigen Berührungsspannung liegenden, Versorgungsspannung auch bei geöffnetem Elektronik-Gehäuse - ferner zudem auch dafür eingerichtet, in der ersten Endlage zumindest das mit dem ersten Steckverbinderteil 19 verbundene Steckverbinderteil 20, mithin den so gebildten Steckverbinder 15 soweit abzudecken, daß auch bei geöffnetem Elektronik-Gehäuse ein Berühren spannungsführender Teile der Anschlußvorrichtung verhindert ist. Im hier gezeigten Ausführungsbeispiel ist die Abdeckklappe 16 - wie aus der in Fig. 2a bzw. 2b gezeigten Konstellation jeweils ohne weiteres ersichtlich - dafür so ausgebildet, daß sie in der ersten Endlage den Steckverbinder 15 nahezu vollständig überdeckt bzw. nahezu vollständig einhüllt.

In Fig. 3a, 3b bzw. 3c ist die Abdeckklappe 16 jeweils in einer geöffneten Position - in Fig. 3b bzw. 3c nämlich jeweils in mit der zweiten Endlage koinzidenter Öffnungsstellung - gezeigt, wobei die Fig. 3a und 3b jeweils die Abdeckklappe 16 in einer Öffnungsstellung bei zugleich auf das Steckverbinderteil 19 aufgestecktem Steckverbinderteil 20 zeigen. Es ist ohne weiteres zu erkennen, dass das Steckverbinderteil 19 des Steckverbinders 15 auf unmittelbar auf der Netzplatine 13 montiert ist und daß der Steckverbinderteil 20 bei in die Öffnungsstellung verschwenkter Abdeckklappe mit dem Steckverbinderteil 19 zusammensteckbar bzw. davon wieder abziehbar ist. Bei abgenommenem Gehäuse-Deckel H" und zugleich in Öffnungsstellung verschwenkter Abdeckklappe 16 liegt der Steckverbinder 15 soweit frei, daß dessen Steckverbinderteil 20 durch eine Bedienperson vom Steckverbinderteil 19 leicht abgezogen werden kann, etwa um die Gerät-Elektronik von der Versorgungsschaltung bzw. vom Netz zu trennen. Die Bedienperson kann das Steckverbinderteil 20 bei in nämliche Öffnungsstellung verschwenkter Abdeckklappe zudem auch wieder auf das Steckverbinderteil 19 aufstecken, um auf diese Weise die Gerät-Elektronik mit der Anschlußleitung elektrisch zu verbinden bzw. das Feldgerät an die Versorgungsschaltung elektrisch anzuschließen. Nach dem Einstecken des Steckverbinderteils 20 in das Steckverbinderteil 19 kann die Abdeckklappe 16 geschlossen werden, indem sie durch Verschwenken aus der Öffnungsstellung in die erste Endlage verbracht wird. Dies ist in Fig. 3b durch den Pfeil 27 schematisiert veranschaulicht. Anschließend kann zudem auch der Gehäuse-Deckel H" wieder am Gehäuse-Grundkörper H` angeschraubt werden.

Desweiteren ist die Abdeckklappe 16 der erfindungsgemäßen Anschlußvorrichtung auch dafür vorgesehen bzw. eingerichtet, zumindest in der ersten Endlage das mit dem Steckverbinderteil 19 verbunden Steckverbinderteil 20 zu fixieren; dies im besonderen in der Weise, daß eine mit weniger als 15 N auf das zweite Steckverbinderteil 20 wirkende Abzugskraft kein Abziehen der wenigstens einen Kontakthülse des zweiten Steckverbinderteils 20 vom wenigstens einen Kontaktstift des ersten Steckverbinderteils 19 bewirkt, und/oder derart, daß zum Abziehen der wenigstens einen Kontakthülse 20' des Steckverbinderteils 20 vom wenigstens einen Kontaktstift 19' des Steckverbinderteils 19 eine Abzugskraft von mehr als 15 N erforderlich ist. Dafür weist die Abdeckklappe nach einer Ausgestaltung der Erfindung auf einer dem Steckverbinder zugewandten Innenseite zumindest einen Kontaktbereich 16+, nämlich einen Teilbereich auf, der dafür eingerichtet ist, das mit dem ersten Steckverbinderteil 19 verbundene zweite Steckverbinderteil 20 zu kontaktieren, und weist ferner das in das Steckverbinderteil 19 eingesteckte Steckverbinderteil 20 auf einer der Abdeckklappe 16 zugewandten Außenseite zumindest einen mit dem Kontaktbereich 16+ der Abdeckklappe 16 korrespondierenden Kontaktbereich 20+, nämlich einem Teilbereich, der dafür eingerichtet ist, den Kontaktbereich 16+ der Abdeckklappe 16 zu kontaktieren, auf.

In vorteilhafter Weise kann der auf der Außenseite des Steckverbinderteils 20 aufliegende Teilbereich der Abdeckklappe 16 komplementär hierbei zu nämlicher Außenseite auch so geformt bzw. so ausgebildet sein, daß nämlicher Teilbereich der Abdeckklappe 16 zumindest teilweise flächig auf nämlicher Außenseite des Steckverbinderteils 20 aufliegt und zugleich ein das Lösen des Steckverbinderteil 20 vom Steckverbinderteil 19 verhindernden bzw. einem Abziehen des Steckverbinderteils 20 vom Steckverbinderteil 19 entgegenwirkenden Formschluß gebildet ist. Nach einer weiteren Ausgestaltung der Erfindung ist die Abdeckklappe 16 daher ferner dafür eingerichtet, das das mit dem ersten Steckverbinderteil 19 verbundene zweite Steckverbinderteil 20 unter Bildung eines, insb. nämlich einem Abziehen des Steckverbinderteils 20 vom Steckverbinderteil 19 entgegenwirkenden, Formschlusses zwischen Abdeckklappe 16 und Steckverbinderteil 20 zu kontaktieren.

Dafür ist die Abdeckklappe 16 nach einer weiteren Ausgestaltung der Erfindung ferner dafür eingerichtet, in der ersten Endlage mit zumindest dem Kontaktbereich 16+ den - hier im wesentlichen dazu komplementären - Kontaktbereich 20+ des Steckverbinderteils 20 zu kontaktieren bzw. weist der Kontaktbereich 16+ eine zu einer Form des Kontaktbereichs20+ komplementäre Form auf. Der Kontaktbereich 16+ und der Kontaktbereich20+ können zur Erzielung einer ausreichend hohen, nämlich eine Abzugskraft von mindestens 15 N erfordernden, Haltekraft beispielsweise also so geformt und so ausgebildet sein, daß bei in die erste Endlage verbrachter Abdeckklappe 16 im Zusammenwirken nämlicher Kontaktbereiche 16+, 20+ ein einem Abziehen des Steckverbinderteils 20 vom Steckverbinderteil 19 entgegenwirkender Formschluß zwischen Abdeckklappe 16 und dem Steckverbinderteil 20 gebildet ist.

Der Kontaktbereich 16+ der Abdeckklappe 16 kann ferner so ausgebildet sein, daß er wenigstens ein, beispielsweise stiftförmiges oder stegförmiges, Formelement 24 aufweist, das in der ersten Endlage der Abdeckklappe 16 den Kontaktbereich 20+ des Steckverbinderteils 20 entsprechend kontaktiert bzw. daß er mittels eines solchen Formelements 24 gebildet ist. Im in der Fig. 3a, 3b, 3c, jeweils gezeigten Ausführungsbeispiel dient ein auf der dem Steckverbinder 15 zugewandten Innenseite der Abdeckklappe 16 vorgesehener Steg als Formelement 24, mithin zur Bildung des vorgenannten Kontaktbereichs 16+.

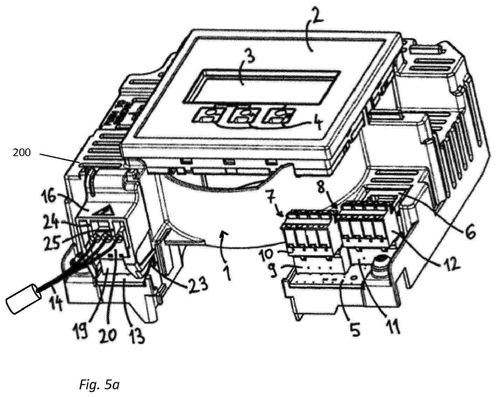

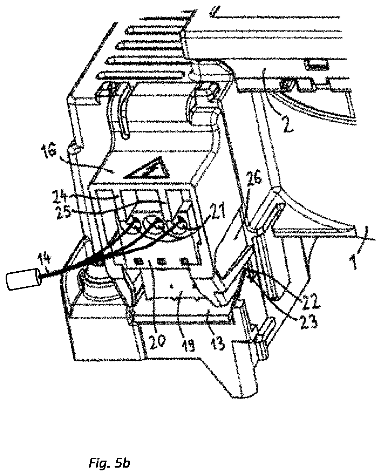

Die Funktion des hier als Steg ausgebildeten Formelements 24 ist nochmals in den Fig. 5a, 5b verdeutlicht. Die auch hier jeweils in die erste Endlage verbrachte Abdeckklappe 16 ist dabei jeweils entlang einer gedachten Schnittebene aufgeschnitten dargestellt, so daß zugleich auch der unterhalb der Abdeckklappe 16 plazierte Steckverbinder erkennbar ist. Das Steckverbinderteil 20 ist entsprechend mit dem - hier auf die Netzplatine 13 aufgesetzten - Steckverbinderteil 19 zusammengesteckt gezeigt. Das Steckverbinderteil 20 weist drei Federklemmelemente 21 auf, in denen die entsprechenden - beispielsweise jeweils als massiver Draht bzw. als Litzen ausgebildeten - Adern der Anschlußleitung 14 festgeklemmt sind, über die dem Feldgerät wiederum die benötigte Versorgungsspannung zugeführt werden kann. Für den hier dargestellten Fall, daß die Abdeckklappe 16 in die geschlossene Position, nämlich in die erste Endlage verbracht ist, liegt das Formteil 24 der Abdeckklappe 16 auf dem zweiten Steckverbinderteil 20, wodurch der Steckverbinder 15 gegen eine allfälliges Auftrennen gesichert ist.

Wie aus einer Zusammenschau der Fig. 5a bzw. 5b mit den Fig. 3a bzw. 3b ohne weiteres ersichtlich, ist im hier gezeigten Ausführungsbeispiel neben dem Formelement 24 ein weiteres - hier zum Formelement 24 im wesentlich formgleiches - Formelement 25 auf der Innenseite der Abdeckklappe 16 vorgesehen. Jedes der wenigstens zwei - hier nämlich als zueinander im wesentlichen parallele Stege ausgebildeten - Formelemente 24, 25 ist zudem so geformt, dass deren - hier nämlich den Kontaktbereich 16+ bildenden - Unterseiten zum Kontaktbereich 20+ des eingesteckten Steckverbinderteils 20 zumindest abschnittsweise komplementär ausgebildet sind; dies im besonderen auch in der Weise, daß in erster Endlage der Abdeckklappe 16 jeder der beiden - hier jeweils stegförmigen - Formelemente 24, 25 das zweite Steckverbinderteil 20 flächig kontaktiert. Dabei ist die Höhe jedes der beiden Formelemente 24, 25 so bemessen, dass das jeweilige untere Ende jedes der beiden Stege 24, 25 den Kontaktbereich 20+ des darunter befindlichen Steckverbinderteils 20 flächig kontaktiert, wodurch im Ergebnis ein selbsttägiges bzw. unbeabsichtigtes Abziehen des Steckverbinderteils 20, nicht zuletzt auch bei Vibrationen des Elektronik-Gehäuses bzw. des Grundkörpers 200, verhindert ist. Darüberhinaus kann ein Abstand zwischen einem jeweiligen der Achse 17 zugewandten Ende jedes der Formelemente 24, 25 von nämlicher Achse 17 ferner so bemessen sein, daß zudem zusätzlich auch zumindest eines dieser Enden bei in erster Endlage befindlicher Abdeckklappe 16 einen weiteren korrespondierenden Kontaktbereich des Steckverbinderteils 20 kontaktiert um die Haltewirkung des Formschlusses zwischen Abdeckklappe 16 und Steckverbinderteil 20 weiter zu verbessern.

Die Fixation des mit dem Steckverbinderteil 19 verbundenen Steckverbinderteils 20 kann darüberhinaus aber auch durch weitere, beispielsweise auch ein spontanes Öffnen der Abdeckklappe 16 im Betrieb des Feldgeräts unterbindende Maßnahmen, wie z.B. entsprechende Rastelemente der Anschlußvorrichtung und/oder am Gehäuse-Deckel vorgesehene weiter Formelemente unterstützt werden. Nach einer weiteren Ausgestaltung der Erfindung sind Abdeckklappe 19 und Grundkörper 200 daher ferner dafür eingerichtet, in der ersten Endlage der Abdeckklappe 16 eine Schnappverbindung, nämliche eine solche Verbindung zu bilden, bei der unter Ausnutzung von der Abdeckklappe 19 und dem Grundkörper 200 jeweils innwohnenden Elastizität ein durch Betätigen wiederlösbarer Formschluß zwischen Abdeckklappe 19 und Grundkörper 200 hergestellt ist.

Zur Bildung einer solchen Schnappverbindung ist die Abdeckklappe gemäß der Erfindung im besonderen auch dafür eingerichtet, in der ersten Endlage mittels wenigstens eines Rastelements 22 in ein korrespondierendes Rastelement 23 des Grundkörpers 200 unter Bildung eines - hier selbsthaltenden, gleichwohl wieder lösbaren - Formschlusses einzurasten. Wie aus einer Zusammenschau der Fig. 2a, 2b, 3a, 3b bzw. 3c ohne weiteres ersichtlich, ist das Rastelement 22 der Abdeckklappe 16 im hier gezeigten Ausführungsbeispiel im wesentlichen hakenförmiges ausgebildet, während das mit nämlichem wenigstens einen hakenförmigen Rastelement 22 der Abdeckklappe korrespondierende Rastelement 23 des Grundkörpers 200 lediglich durch einen am Grundkörper 200 vorgesehenen Steg bzw. eine am Grundkörper vorgesehene Rippe gebildet ist. Das Rastelement 23 des Grundkörpers 200 kann aber beispielsweise auch im wesentlichen hakenförmig oder aber auch im wesentlichen ösenförmig ausgebildet sein. In Fig. 2a bzw. 2b ist erkennbar, daß bei in die erste Endlage verbrachter Abdeckklappe 16 das Rastelement 22 in das Rastelement 23 eigerastet ist, indem ein hakenförmiger Endbereich des Rastelements 22 in Schließrichtung gesehen hinter dem Rastelement 23 plaziert ist. Um eine möglichst leichtgängiges Einrasten des Rastelements 22 in das Rastelement 23 zu ermöglichen, ist der vorbezeichnete hakenförmiger Endbereich des Rastelement 22, wie auch in den Fig. 3a, 3b und 3c jeweils ohne weiteres zu erkennen, an einer - in Schließrichtung gesehen - vorderen Seite angeschrägt, derart, daß beim Schließen der Abdeckklappe 16 das Rastelement 23 des Grundkörpers 200 von nämlicher Vorderseite etwas zur Seite gedrückt wird, um hernach, nämlich nachdem der hakenförmige Bereich das Rastelement 23 passierte hat, wieder selbsttätig zurückschnappen zu können und so das Rastelement 22 zu arretieren. Dadurch ist die Abdeckklappe 16 in der ersten Endlage fixiert, wodurch auch der darunter befindlichen Steckverbinder 15 gegen unbeabsichtigtes bzw. selbsttätiges Lösen gesichert ist. Ein Öffnen der Abdeckklappe 16 ist im hier gezeigten Ausführungsbeispiel umgekehrt nur möglich, indem von einer Bedienperson gegen eine in die Abdeckklappe 16 eingeformte Griffmulde 26 gedrückt wird. Infolge einer dadurch auf die Griffmulde 26 ausgeübten Verformungskraft bewegt sich nämlich das Rastelement 22 nach innen in Richtung des Steckverbinders 19 bzw. weg vom Rastelement 23 des Grundkörpers 200. Die Verformungskraft muß dabei so groß sein, daß das Rastelement 22 wieder vollständig vom Rastelement freigegeben ist und die Verrastung zwischen den beiden Rastelement 22, 23 wieder vollständig gelöst. Umgekehrt müssen die durch die Abdeckklappe 16 aufgebrachten, nämlich einer ein Öffnen der Abdeckklappe erlaubenden Verformung entgegenwirkenden Rückstellkräfte ausreichend hoch sein, daß ein spontanes Lösen des Schnappverschlusses bzw. ein spontanes Öffnen der Abdeckklappe 16 im Betrieb des Feldgeräts, nicht zuletzt auch bei Vibrationen des Elektronik-Gehäuses bzw. der darin untergebrachten Gerät-Elektronik sicher vermieden ist.

In Fig. 6 ist schließlich noch einer weitere Variante der Erfindung gezeigt, bei zur Fixation der in die erste Endlage verbrachten Abdeckklappe 16, mithin zur Sicherung des durch Verbinden des Steckverbinderteils 20 mit dem Steckverbinderteil 19 hergestellten Steckverbinders der Gehäuse-Deckel H"und die Abdeckklappe 16 dafür eingerichtet sind, einander in Einbaulage, nämlich bei in erster Endlage befindlicher Abdeckklappe 16 und mit dem Gehäuse-Grundkörper H` verbundenem Gehäuse-Deckel H", zu kontaktieren, insb. nämlich derart, daß ein einem Verschwenken der Abdeckklappe aus der ersten Endlage entgegenwirkender Kraft- und/oder Formschluß zwischen Abdeckklappe und Gehäuse-Deckel gebildet ist. Dafür weist der Gehäuse-Deckel H" auf einer der Anschlußvorrichtung bzw. der Gerät-Elektronik zugewandten Innenseite zumindest einen Kontaktbereich H#, nämlich einen Teilbereich auf, der dafür eingerichtet ist, die in ersten Endlage befindliche Abdeckklappe 16 zu kontaktieren, und weist die Abdeckklappe 16 auf einer dem Gehäuse-Deckel zugewandte Außenseite zumindest einen mit nämlichem Kontaktbereich H# des Gehäuse-Deckels H` korrespondierenden Kontaktbereich 16#, nämlich einem Teilbereich auf, der dafür eingerichtet ist, in Einbaulage den Kontaktbereich H# des Gehäuse-Deckels zu kontaktieren. Wie in Fig. 6 schematisch dargestellt, kann der Kontaktbereich H# des Gehäuse-Deckels dadurch gebildet sein, daß der Gehäuse-Deckel auf der der der Anschlußvorrichtung bzw. der Gerät-Elektronik zugewandten Innenseite wenigstens ein - beispielsweise stiftförmiges oder stegförmiges - Formelement 30 aufweist, das dafür eingerichtet ist, in Einbaulage unter Bildung des Kontaktbereichs H# den korrespondierenden Kontaktbereich 16# der in der ersten Endlage befindlichen Abdeckklappe 16, etwa unter Bildung eines Formschlusses zwischen Gehäuse-Deckel und Abdeckklappe, zu kontaktieren. Ein so gebildeter Formschluß kann darüberhinaus auch so ausgelegt sein, daß in Einbaulage nämliches Formelement 30 die Abdeckklappe 16 in der ersten Endlage spielfrei fixiert, beispielsweise indem das Formelement 30 so bemessen ist, daß es in Einbaulage zusätzlich eine Verformungskraft erfährt, die eine geringfügige, gleichwohl für die Fixation der Abdeckklappe 16 in der ersten Endlage ausreichende elastische Verformung des Formelements 30 bewirkt.

Nicht zuletzt bei Verwendung des vorgenannten Formelements 30, aber beispielsweise für den erwähnten Fall, daß zwischen dem Grundkörper und der in die erste Endlage verbrachten Abdeckklappe 16 eine Schnappverbindung gebildet ist, können die Abdeckklappe 16 und der Steckverbinder 15 ferner so aufeinander abgestimmt bemessen sein, daß bei in Endlage verbrachter Abdeckklappe 16 diese und/oder der Steckverbinder 15 elastisch so verformt werden, daß im Ergebnis zusätzliche, das Steckverbinderteil 20 gegen Steckverbinderteil 19 gedrückt haltende Haltkräfte in der Anschlußvorrichtung erzeugt werden, wodurch das mit dem Steckverbinderteil 19 verbundene Steckverbinderteil 20 noch besser gegen ein allfälliges Lösen vom Steckverbinderteil 19 zu gesichert werden kann. Dies kann beispielsweise durch eine für die Formelement 24, 25 passend ausgelegten Höhe sehr einfach realisiert werden.

## Patentansprüche

1. Feldgerät, insb. Meß- und/oder Schaltgerät, umfassend:
- ein, insb. zumindest anteilig aus einem elektrisch isolierenden Kunststoff bestehendes, Elektronik-Gehäuse (H);
- eine Anschlußvorrichtung (10, 20) zum elektrischen Verbinden einer Schaltung eines Feldgeräts mit einer teilweise extern des Elektronik-Gehäuses (H) des Feldgeräts verlegten zwei- oder mehradrigen Anschlußleitung (14);
- sowie eine, insb. mit nämlicher Anschlußvorrichtung elektrisch verbundene und/oder eine an den wenigstens einen Kontaktstift des ersten Steckverbinderteils (19) elektrisch angeschlossene Schaltung aufweisende, Gerät-Elektronik;
- wobei die Anschlußvorrichtung
-- einen, insb. zumindest anteilig aus einem elektrisch isolierenden Kunststoff bestehenden, Grundkörper (200),
-- einen Steckverbinder (15)
--- mit einem am Grundkörper (200) fixierten, an die Schaltung des Feldgeräts elektrisch angeschlossenen, insb. als Einbaustecker ausgebildeten, ersten Steckverbinderteil (19) und
--- mit einem mit der Anschlußleitung verbindbaren, zum ersten Steckverbinderteil (19) komplementären, insb. als Kupplung ausgebildeten, zweiten Steckverbinderteil (20)
-- sowie eine, insb. zumindest anteilig aus einem elektrisch isolierenden Kunststoff bestehende, am Grundkörper (200) beweglich - insb. um eine Achse (17) verschwenkbar- gehalterte Abdeckklappe (16) zum zumindest teilweisen Abdecken des Steckverbinders (15) umfaßt;
-- wobei das erste Steckverbinderteil (19) wenigstens einen an die Schaltung des Feldgeräts elektrisch angeschlossenen Kontaktstift und das zweite Steckverbinderteil (20) wenigstens eine, insb. mit zumindest einer Ader der Anschlußleitung (L1, L2) elektrisch verbindbare, Kontakthülse aufweisen,
-- und wobei das erste Steckverbinderteil (19) und das zweite Steckverbinderteil (20) wieder lösbar miteinander verbunden sind, insb. derart, daß die wenigstens eine Kontakthülse des zweiten Steckverbinderteils (20) auf den wenigstens einen Kontaktstift des ersten Steckverbinderteils (19) unter Bildung eines Reibschlusses aufgesteckt ist und diesen elektrisch leitend kontaktiert;
-- wobei die Abdeckklappe (16) wenigstens ein Rastelement (22) und der Grundkörper (200) ein mit dem wenigstens einen Rastelement (22) der Abdeckklappe (23) korrespondierendes Rastelement (23) aufweisen;
-- wobei die Abdeckklappe (16) zwischen einer ersten Endlage, in der die Abdeckklappe (16) den Steckverbinder, insb. unter Bildung eines Formschlusses zwischen Abdeckklappe (16) und zweitem Steckverbinderteil (20), zumindest teilweise abdeckt, und einer zweiten Endlage, insb. um eine Achse (17), verschwenkbar ist und
-- wobei die Abdeckklappe (16) dafür eingerichtet ist,
--- in zumindest einer zwischen der ersten Endlage und der zweiten Endlage befindlichen Öffnungsstellung den Steckverbinder soweit freizugegeben, daß die wenigstens eine Kontakthülse des zweiten Steckverbinderteils (20) vom wenigstens einen Kontaktstift des ersten Steckverbinderteils (19) entlang einer vorgegebenen Abzugsbahn abziehbar ist, indem das zweite Steckverbinderteil (20), insb. unter Aufbietung einer in einer Richtung der Abzugsbahn wirkenden Abzugskraft, vom ersten Steckverbinderteil (19) getrennt wird, und
--- zumindest in der ersten Endlage das mit dem ersten Steckverbinderteil (19) verbundene zweite Steckverbinderteil (20) zu fixieren, insb. derart, daß eine mit weniger als 15 N auf das zweite Steckverbinderteil (20) wirkende Abzugskraft kein Abziehen der wenigstens einen Kontakthülse des zweiten Steckverbinderteils (20) vom wenigstens einen Kontaktstift des ersten Steckverbinderteils (19) bewirkt, und/oder derart, daß zum Abziehen der wenigstens einen Kontakthülse des zweiten Steckverbinderteils (20) vom wenigstens einen Kontaktstift des ersten Steckverbinderteils (19) eine Abzugskraft von mehr als 15 N erforderlich ist;
-- und wobei die Abdeckklappe dafür eingerichtet ist, in der ersten Endlage mit dem wenigstens einen Rastelement in das korrespondierende Rastelement des Grundkörpers (200) unter Bildung eines - insb. selbsthaltenden, gleichwohl wieder lösbaren und/oder eine Schnappverbindung bildenden - Formschlusses einzurasten;
- und wobei sowohl die Anschlußvorrichtung als auch die Gerät-Elektronik (30) innerhalb des Elektronik-Gehäuses (H) untergebracht sind, insb. derart, daß die Abdeckklappe (16) der Anschlußvorrichtung in der ersten Endlage positioniert ist.

2. Feldgerät nach Anspruch 1,
- wobei das wenigstens eine Rastelement (22) der Abdeckklappe (16) hakenförmig ist, und/oder
- wobei das Rastelement (23) des Grundkörpers (200) hakenförmig oder ösenförmig ist.

3. Feldgerät nach einem der vorherigen Ansprüche,
- wobei die Abdeckklappe, insb. nämlich auf einer dem Steckverbinder zugewandten Innenseite, zumindest einen Kontaktbereich, nämlich einen Teilbereich, der dafür eingerichtet ist, das mit dem ersten Steckverbinderteil verbundene zweite Steckverbinderteil (20) zu kontaktieren, aufweist, und
- wobei das mit dem ersten Steckverbinderteil verbundene zweite Steckverbinderteil, insb. nämlich auf einer der Abdeckklappe zugewandten Außenseite, zumindest einen mit dem Kontaktbereich der Abdeckklappe korrespondierenden Kontaktbereich, nämlich einem Teilbereich, der dafür eingerichtet ist, den Kontaktbereich der Abdeckklappe zu kontaktieren, aufweist.

4. Feldgerät nach dem vorherigen Anspruch,
- wobei die Abdeckklappe dafür eingerichtet ist, in der ersten Endlage mit zumindest dem Kontaktbereich den, insb. komplementären, Kontaktbereich des zweiten Steckverbinderteils (20), inbs. unter Bildung eines einem Abziehen des zweiten Steckverbinderteils (20) vom ersten Steckverbinderteil (19) entgegenwirkenden Formschlusses, zu kontaktieren; und/oder
- wobei der Kontaktbereich der Abdeckklappe eine zu einer Form des Kontaktbereichs des zweiten Steckverbinderteils (20) komplementäre Form aufweist, insb. nämlich derart, daß in der ersten Endlage der Abdeckklappe im Zusammenwirken des Kontaktbereichs der Abdeckklappe und des Kontaktbereichs des zweiten Steckverbinderteils (20) ein einem Abziehen des zweiten Steckverbinderteils (20) vom ersten Steckverbinderteil (19) entgegenwirkender Formschluß zwischen Abdeckklappe (16) und zweitem Steckverbinderteil (20) gebildet ist; und/oder
- wobei der Kontaktbereich der Abdeckklappe wenigstens ein, insb. stiftförmiges oder stegförmiges, Formelement aufweist, das in der ersten Endlage der Abdeckklappe den Kontaktbereich des zweiten Steckverbinderteils, insb. unter Bildung eines Formschlusses zwischen Abdeckklappe und zweitem Steckverbinderteil, kontaktiert.

5. Feldgerät nach einem der vorherigen Ansprüche, wobei die Abdeckklappe und das zweite Steckverbinderteil dafür eingerichtet sind, in der ersten Endlage der Abdeckklappe einen einem Abziehen des zweiten Steckverbinderteils (20) vom ersten Steckverbinderteil (19) entgegenwirkenden Formschluß zu bilden.

6. Feldgerät nach einem der vorherigen Ansprüche, wobei die Abdeckklappe (16) dafür eingerichtet ist, in der ersten Endlage das mit dem ersten Steckverbinderteil (19) verbundene zweite Steckverbinderteil (20) zu fixieren, indem die Abdeckklappe das zweite Steckverbinderteil gegen das erste Steckverbinderteil gedrückt hält.

7. Feldgerät nach einem der vorherigen Ansprüche, wobei der Grundkörper und die Abdeckklappe dafür eingerichtet sind, in der ersten Endlage der Abdeckklappe eine Schnappverbindung zu bilden.

8. Feldgerät nach einem der vorherigen Ansprüche, wobei das Elektronik-Gehäuse (H) einen, insb. kastenförmigen oder topfförmigen, Gehäuse-Grundkörper (H') sowie einen diesen verschließenden, insb. zumindest anteilig aus einem Kunststoff bestehenden und/oder insb. mittels Schraubverbindung wieder lösbar am Gehäuse-Grundkörper fixierbaren, Gehäuse-Deckel (H") umfaßt.

9. Feldgerät nach Anspruch 8, wobei der Gehäuse-Deckel (H"), insb. mittels Schraubverbindung, wieder lösbar am Gehäuse-Grundkörper (H') fixiert ist.

10. Feldgerät nach Anspruch 9,
- wobei der Gehäuse-Deckel (H"), insb. nämlich auf einer der Anschlußvorrichtung zugewandten Innenseite, zumindest einen Kontaktbereich (H#), nämlich einen Teilbereich, der dafür eingerichtet ist, die in ersten Endlage befindliche Abdeckklappe (16) zu kontaktieren, aufweist, und
- wobei die Abdeckklappe, insb. nämlich auf einer dem Gehäuse-Deckel (H") zugewandte Außenseite, zumindest einen mit dem Kontaktbereich des Gehäuse-Deckels korrespondierenden Kontaktbereich (16#), nämlich einen Teilbereich, der dafür eingerichtet ist, den Kontaktbereich (H#) des Gehäuse-Deckels zu kontaktieren, aufweist.

11. Feldgerät nach dem vorherigen Anspruch,
- wobei der Gehäuse-Deckel (H") dafür eingerichtet ist, mit zumindest dem Kontaktbereich den korrespondierenden Kontaktbereich der Abdeckklappe, insb. unter Bildung eines einem Verschwenken der Abdeckklappe aus der ersten Endlage entgegenwirkenden Kraft- und/oder Formschlusses, zu kontaktieren; und/oder
- wobei der Kontaktbereich des Gehäuse-Deckels wenigstens ein, insb. stiftförmiges oder stegförmiges, Formelement aufweist, das dafür eingerichtet ist, den Kontaktbereich der in der ersten Endlage befindlichen Abdeckklappe (16), insb. unter Bildung eines Formschlusses zwischen Gehäuse-Deckel und Abdeckklappe, zu kontaktieren, insb. derart, daß nämliches Formelement die Abdeckklappe in der ersten Endlage fixiert.

12. Feldgerät nach einem der vorherigen Ansprüche, weiters umfassend:
- einen, insb. an die Gerät-Elektronik elektrisch angeschlossenen, Meßaufnehmer (S) zum Erzeugen wenigstens eines von einer zu erfassenden physikalischen Meßgröße abhängigen Meßsignals; und/oder
- eine mittels der Anschlußvorrichtung mit der Gerät-Elektronik elektrisch verbundene, insb. extern des Elektronik-Gehäuses verlegte und/oder zwei- oder mehradrige und/oder mit der wenigstens einen Kontakthülse des zweiten Steckverbinderteils (20) elektrisch verbundene, Anschlußleitung (14).

13. Verfahren zum Anschließen mindestens einer elektrischen Anschlußleitung (14) an ein Feldgerät gemäß einem der vorherigen Ansprüche, welches Verfahren umfaßt:
- elektrisches Anschließen der Anschlußleitung (14) an das zweite Steckverbinderteil (20);
- Verschwenken der Abdeckklappe in die Öffnungsstellung zum Verbinden des zweiten Steckverbinderteils (20) mit dem ersten Steckverbinderteil (19);
- Verbinden des zweiten Steckverbinderteils (20) mit dem ersten Steckverbinderteil (19), insb. derart, daß die wenigstens eine Kontakthülse (20') des zweiten Steckverbinderteils (20) auf den wenigstens einen Kontaktstift (19') des ersten Steckverbinderteils (19) aufgesteckt wird;
- Verschwenken der Abdeckklappe in die erste Endlage zum Fixieren des zweiten Steckverbinderteils (20) im ersten Steckverbinderteil (19); und
- Einrasten des Rastelements (22) der in erster Endlage befindlichen Abdeckklappe (16) in das korrespondierende Rastelement (23) des Grundkörpers (200) zum Fixieren der Abdeckklappe und/oder zum Bilden einer Schnappverbindung zwischen Grundkörper und Abdeckklappe.

## Claims

1. A field device, in particular a measuring and/or switching device, comprising:
- An electronics housing (H), in particular consisting at least in part of an electrically non-conductive plastic;
- a connecting device (10, 20) for electrically connecting a circuit of a field device to a two-core or multi-core connecting line (14) routed partially outside the electronics housing (H) of the field device;
- as well as device electronics, in particular which are electrically connected to said connecting device and/or which have a circuit which is electrically connected to the at least one contacting pin of the first plug connector part (19);
- wherein the connecting device comprises
a basic body (200), in particular consisting at least in part of an electrically non-conductive plastic,
a plug connector (15)
with a first plug connector part (19) which is fixed to the basic body (200) and
is electrically connected to the circuit of the field device, in particular configured as an installation connector, and
with a second plug connector part (20) which can be connected to the connecting line and complements the first plug connector part (19), in particular configured as a coupling,
as well as a protective cap (16), in particular consisting at least in part of an electrically non-conductive plastic, which is movably mounted on the basic body (200) - in particular which can be moved about an axis (17) - for at least partially covering the plug connector (15);
wherein the first plug connector part (19) has at least one contacting pin which is electrically connected to the circuit of the field device, and the second plug connector part (20) has at least one contacting sleeve which can in particular be electrically connected to at least one core of the connecting line (L1, L2),
and wherein the first plug connector part (19) and the second plug connector part (20) are connected together in such a way that they can be separated again, in particular in such a way that the at least one contacting sleeve of the second plug connector part (20) is fitted to the at least one contacting pin of the first plug connector part (19), forming a frictional connection and contacting it in such a way that it conducts electricity;
wherein the protective cap (16) has at least one locking element (22) and the basic body (200) has a locking element (23) which corresponds to the at least one locking element (22) of the protective cap (16); wherein the protective cap (16) can be moved between a first end position in which the protective cap (16) at least partially covers the plug connector, in particular forming an interlocking connection between the protective cap (16) and the second plug connector part (20), and a second end position, in particular about an axis (17), and wherein the protective cap (16) is configured to
release the plug connector in at least one opening position located between the first end position and the second end position to such an extent that the at least one contacting sleeve of the second plug connector part (20) can be removed from the at least one contacting pin of the first plug connector part (19) along a prespecified removal path, in that the second plug connector part (20) is separated from the first plug connector part (19), in particular exerting a removal force which acts in one direction of the removal path, and to fix the second plug connector part (20) which is connected to the first plug connector part (19) at least in the first end position, in particular in such a way that a removal force of less than 15 N impacting on the second plug connector part (20) will not cause the at least one contacting sleeve of the second plug connector part (20) to be removed from the at least one contacting pin of the first plug connector part (19), and/or in such a way that a removal force of more than 15 N is needed to remove the at least one contacting sleeve of the second plug connector part (20) from the at least one contacting pin of the first plug connector part (19);
- and wherein the protective cap is configured to latch into the corresponding locking element of the basic body (200) together with the at least one locking element in the first end position, forming an interlocking connection - in particular one that is self-retaining yet can be separated again and/or forms a snap-in connection;
- and wherein both the connecting device and the device electronics (30) are housed inside the electronics housing (H), in particular in such a way that the protective cap (16) of the connecting device is positioned in the first end position.

2. The field device as claimed in claim 1,
- wherein the at least one locking element (22) of the protective cap (16) is hook-shaped, and/or
- wherein the locking element (23) of the basic body (200) is hook-shaped or eyelet-shaped.

3. The field device as claimed in one of the preceding claims,
- wherein the protective cap, in particular namely on an inner side facing the plug connector,
has at least one contact area, namely a partial area, which is configured to contact the second plug connector part (20) which is connected to the first plug connector part, and
- wherein the second plug connector part connected to the first plug connector part, in particular namely on an outer side facing the protective cap, has at least one contact area corresponding to the contact area of the protective cap, namely a partial area which is configured to contact the contact area of the protective cap.

4. The field device as claimed in the preceding claim,
- wherein the protective cap is configured to contact the, in particular complementary, contact area of the second plug connector part (20) in the first end position together with at least the contact area, in particular forming an interlocking connection in order to prevent the second plug connector part (20) from being removed from the first plug connector part (19); and/or
- wherein the contact area of the protective cap has a shape which complements the shape of the contact area of the second plug connector part (20), in particular namely in such a way that in the first end position of the protective cap, an interlocking connection is formed between the protective cap (16) and the second plug connector part (20) in conjunction with the contact area of the protective cap and the contact area of the second plug connector part (20) to prevent the second plug connector part (20) from being removed from the first plug connector part (19); and/or
- wherein the contact area of the protective cap has at least one, in particular pin-shaped or bar-shaped, shaping element which contacts the contact area of the second plug connector part in the first end position in the protective cap, in particular forming an interlocking connection between the protective cap and the second plug connector part.

5. The field device as claimed in one of the preceding claims, wherein the protective cap and the second plug connector part are configured to create an interlocking connection in the first end position of the protective cap in order to prevent the second plug connector part (20) from being removed from the first plug connector part (19).

6. The field device as claimed in one of the preceding claims, wherein the protective cap (16) is configured to fix the second plug connector part (20) which is connected to the first plug connector part (19) in the first end position in that the protective cap keeps the second plug connector part pressed against the first plug connector part.

7. The field device as claimed in one of the preceding claims, wherein the basic body and the protective cap are configured to form a snap-in connection in the first end position of the protective cap.

8. The field device as claimed in one of the preceding claims, wherein the electronics housing (H) comprises an, in particular box-shaped or pot-shaped, housing basic body (H') and a housing cover (H") which seals this off, in particular which consists at least in part of a plastic and/or which can be fixed to the housing basic body in such a way that it can be removed again, in particular by means of a screw connection.

9. The field device as claimed in claim 8,
wherein the housing cover (H") is fixed to the housing basic body (H') in such a way that it can be removed again, in particular by means of a screw connection.

10. The field device as claimed in claim 9,
- wherein the housing cover (H"), in particular namely on an inner side facing the connecting device, has at least one contact area (H#), namely a partial area which is configured to contact the protective cap (16) which is located in the first end position, and
- wherein the protective cap, in particular namely on an outer side facing the housing cover (H"), has at least one contact area (16#) corresponding to the contact area of the housing cover, namely a partial area, which is configured to contact the contact area (H#) of the housing cover.

11. The field device as claimed in the preceding claim,
- wherein the housing cover (H") is configured to contact the corresponding contact area of the protective cap together with at least the contact area, in particular forming a frictional and/or interlocking connection in order to prevent the protective cap from being moved out of the first end position; and/or
- wherein the contact area of the housing cover has at least one, in particular pin-shaped or bar-shaped, shaping element which is configured to contact the contact area of the protective cap (16) which is located in the first end position, in particular forming an interlocking connection between the housing cover and protective cap, in particular in such a way that said shaping element fixes the protective cap in the first end position.

12. The field device as claimed in one of the preceding claims, further comprising:
- A sensor (S), in particular electrically connected to the device electronics, for generating at least one measurement signal dependent on a physical measured variable to be detected; and/or
- a connecting line (14) which is electrically connected to the device electronics by means of the connecting device, in particular which is routed outside the electronics housing and/or which has two or more cores and/or which is electrically connected to the at least one contacting sleeve of the second plug connector part (20).

13. A method for connecting at least one electrical connecting line (14) to a field device as claimed in one of the preceding claims, said method comprising:
- Electrically connecting the connecting line (14) to the second plug connector part (20);
- moving the protective cap to the opening position in order to connect the second plug connector part (20) to the first plug connector part (19);
- connecting the second plug connector part (20) to the first plug connector part (19), in particular in such a way that the at least one contacting sleeve (20') of the second plug connector part (20) is fitted to the at least one contacting pin (19') of the first plug connector part (19);
- moving the protective cap to the first end position in order to fix the second plug connector part (20) in the first plug connector part (19); and
- latching the locking element (22) of the protective cap (16) which is located in the first end position into the corresponding locking element (23) of the basic body (200) in order to fix the protective cap and/or in order to form a snap-in connection between the basic body and protective cap.

## Revendications

1. Appareil de terrain, notamment un appareil de mesure et/ou de commutation, comprenant :
- un boîtier électronique (H) composé au moins en partie d'une matière plastique électriquement isolante ;
- un dispositif de raccordement (10, 20) destiné à relier électriquement un circuit d'un appareil de terrain à un câble de raccordement (14) à deux ou plusieurs conducteurs posé partiellement à l'extérieur du boîtier électronique (H) de l'appareil de terrain ;
- ainsi qu'un appareil électronique, notamment relié électriquement au même dispositif de raccordement et/ou présentant un circuit raccordé électriquement à l'au moins une broche de contact de la première partie de connecteur (19) ;
- le dispositif de raccordement comprenant
-- un corps de base (200) composé au moins en partie d'une matière plastique électriquement isolante,
-- un connecteur (15)
--- avec une première partie de connecteur (19) fixée sur le corps de base (200), laquelle première partie est raccordée électriquement au circuit de l'appareil de terrain, notamment réalisée sous forme de connecteur encastré, et
--- avec une deuxième partie de connecteur (20) pouvant être reliée au câble de raccordement, laquelle deuxième partie est complémentaire à la première partie de connecteur (19) et notamment conçue en tant que coupleur
-- ainsi qu'un volet de recouvrement (16), constitué notamment au moins en partie d'une matière plastique électriquement isolante, maintenu sur le corps de base (200) de manière mobile, notamment de manière pivotante autour d'un axe (17), lequel volet est destiné à recouvrir au moins partiellement le connecteur (15) ;
-- la première partie de connecteur (19) présentant au moins une broche de contact raccordée électriquement au circuit de l'appareil de terrain et la deuxième partie de connecteur (20) présentant au moins une douille de contact pouvant être raccordée électriquement à au moins un conducteur du câble de raccordement (L1, L2),
-- et la première partie de connecteur (19) et la deuxième partie de connecteur (20) étant reliées l'une à l'autre de manière amovible, notamment de telle sorte que l'au moins une douille de contact de la deuxième partie de connecteur (20) est enfichée sur l'au moins une broche de contact de la première partie de connecteur (19) en formant une liaison par friction et établit un contact électriquement conducteur avec celle-ci ;
-- le volet de recouvrement (16) présentant au moins un élément d'encliquetage (22) et le corps de base (200) présentant un élément d'encliquetage (23) correspondant à l'au moins un élément d'encliquetage (22) du volet de recouvrement (23) ;
-- le volet de recouvrement (16) pouvant pivoter entre une première position d'extrémité, dans laquelle le volet de recouvrement (16) recouvre au moins partiellement le connecteur - notamment en formant une liaison par complémentarité de forme entre le volet de recouvrement (16) et la deuxième partie de connecteur (20) - et une deuxième position d'extrémité, notamment pouvant pivoter autour d'un axe (17), et
-- le volet de recouvrement (16) étant conçu pour,
--- libérer - dans au moins une position d'ouverture se trouvant entre la première position d'extrémité et la deuxième position d'extrémité - le connecteur dans une mesure telle que l'au moins une douille de contact de la deuxième partie de connecteur (20) peut être retirée de l'au moins une broche de contact de la première partie de connecteur (19) le long d'une trajectoire d'extraction prédéfinie, en séparant la deuxième partie de connecteur (20) de la première partie de connecteur (19), notamment en exerçant une force d'extraction agissant dans une direction de la trajectoire d'extraction, et
--- fixer - au moins dans la première position d'extrémité - la deuxième partie de connecteur (20) reliée à la première partie de connecteur (19), notamment de telle sorte qu'une force d'extraction agissant avec moins de 15 N sur la deuxième partie de connecteur (20) ne provoque pas de retrait de l'au moins une douille de contact de la deuxième partie de connecteur (20) par rapport à l'au moins une broche de contact de la première partie de connecteur (19), et/ou de telle sorte qu'une force d'extraction de plus de 15 N est nécessaire pour extraire l'au moins une douille de contact de la deuxième partie de connecteur (20) par rapport à l'au moins une broche de contact de la première partie de connecteur (19) ;
-- et le volet de recouvrement étant conçu pour s'encliqueter, dans la première position d'extrémité, avec l'au moins un élément d'encliquetage dans l'élément d'encliquetage correspondant du corps de base (200) en formant une liaison par complémentarité de forme, notamment automaintenue, néanmoins de manière amovible et/ou formant une liaison par encliquetage ;
- et aussi bien le dispositif de raccordement que l'électronique d'appareil (30) étant logés à l'intérieur du boîtier électronique (H), notamment de telle sorte que le volet de recouvrement (16) du dispositif de raccordement est positionné dans la première position d'extrémité.

2. Appareil de terrain selon la revendication 1,
- pour lequel l'au moins un élément d'encliquetage (22) du volet de recouvrement (16) est en forme de crochet, et/ou
- pour lequel l'élément d'encliquetage (23) du corps de base (200) est en forme de crochet ou d'oeillet.

3. Appareil de terrain selon l'une des revendications précédentes,
- pour lequel le volet de recouvrement présente, notamment sur un côté intérieur tourné vers le connecteur, au moins une zone de contact, à savoir une zone partielle, laquelle est conçue pour entrer en contact avec la deuxième partie de connecteur (20) reliée à la première partie de connecteur, et
- pour lequel la deuxième partie de connecteur reliée à la première partie de connecteur, notamment sur un côté extérieur tourné vers le volet de recouvrement, présente au moins une zone de contact correspondant à la zone de contact du volet de recouvrement, à savoir une zone partielle qui est conçue pour entrer en contact avec la zone de contact du volet de recouvrement.

4. Appareil de terrain selon la revendication précédente,
- pour lequel le volet de recouvrement est conçu pour entrer en contact, dans la première position d'extrémité, par au moins la zone de contact, avec la zone de contact, notamment complémentaire, de la deuxième partie de connecteur (20), notamment en formant une liaison par complémentarité de forme s'opposant à un retrait de la deuxième partie de connecteur (20) de la première partie de connecteur (19) ; et/ou
- pour lequel la zone de contact du volet de recouvrement présente une forme complémentaire à une forme de la zone de contact de la deuxième partie de connecteur (20), notamment de telle sorte que, dans la première position d'extrémité du volet de recouvrement, il se forme entre le volet de recouvrement (16) et la deuxième partie de connecteur (20), par interaction de la zone de contact du volet de recouvrement et de la zone de contact de la deuxième partie de connecteur (20), une liaison par complémentarité de forme s'opposant au retrait de la deuxième partie de connecteur (20) de la première partie de connecteur (19) ; et/ou
- pour lequel la zone de contact du volet de recouvrement présente au moins un élément de forme, notamment en forme de tige ou de nervure, lequel élément entre en contact, dans la première position finale du volet de recouvrement, avec la zone de contact de la deuxième partie de connecteur, notamment en formant une liaison par complémentarité de forme entre le volet de recouvrement et la deuxième partie de connecteur.

5. Appareil de terrain selon l'une des revendications précédentes, pour lequel le volet de recouvrement et la deuxième partie de connecteur sont conçus pour former, dans la première position d'extrémité du volet de recouvrement, une liaison par complémentarité de forme s'opposant à un retrait de la deuxième partie de connecteur (20) de la première partie de connecteur (19).

6. Appareil de terrain selon l'une des revendications précédentes, pour lequel le volet de recouvrement (16) est conçu pour fixer, dans la première position d'extrémité, la deuxième partie de connecteur (20) reliée à la première partie de connecteur (19), en maintenant la deuxième partie de connecteur pressée contre la première partie de connecteur.

7. Appareil de terrain selon l'une des revendications précédentes, pour lequel le corps de base et le volet de recouvrement sont conçus pour former un assemblage par encliquetage dans la première position d'extrémité du volet de recouvrement.

8. Appareil de terrain selon l'une des revendications précédentes, pour lequel le boîtier électronique (H) comprend un corps de base de boîtier (H'), notamment en forme de boîte ou de pot, ainsi qu'un couvercle de boîtier (H") fermant ledit corps de base, lequel couvercle est notamment constitué au moins en partie d'une matière plastique et/ou pouvant être fixé de manière amovible sur le corps de base de boîtier, notamment au moyen d'un assemblage par vis.

9. Appareil de terrain selon la revendication 8,
pour lequel le couvercle de boîtier (H") est fixé de manière amovible sur le corps de base de boîtier (H'), notamment au moyen d'un assemblage par vis.

10. Appareil de terrain selon la revendication 9,
- pour lequel le couvercle de boîtier (H"), notamment sur un côté intérieur tourné vers le dispositif de raccordement, présente au moins une zone de contact (H#), notamment une zone partielle, laquelle est conçue pour entrer en contact avec le volet de recouvrement (16) se trouvant dans la première position d'extrémité, et
- pour lequel le volet de recouvrement, notamment sur un côté extérieur tourné vers le couvercle de boîtier (H"), présente au moins une zone de contact (16#) correspondant à la zone de contact du couvercle de boîtier, à savoir une zone partielle qui est conçue pour entrer en contact avec la zone de contact (H#) du couvercle de boîtier.

11. Appareil de terrain selon la revendication précédente,
- pour lequel le couvercle de boîtier (H") est conçu pour entrer en contact avec au moins la zone de contact de la zone de contact correspondante du volet de recouvrement, notamment en formant une liaison par complémentarité de force et/ou de forme s'opposant à un pivotement du volet de recouvrement à partir de la première position d'extrémité ; et/ou
- pour lequel la zone de contact du couvercle de boîtier présente au moins un élément de forme, notamment en forme de tige ou de nervure, lequel élément est conçu pour entrer en contact avec la zone de contact du volet de recouvrement (16) se trouvant dans la première position d'extrémité, notamment en formant une liaison par complémentarité de forme entre le couvercle de boîtier et le volet de recouvrement, notamment de telle sorte que ledit élément de forme fixe le volet de recouvrement dans la première position d'extrémité.

12. Appareil de terrain selon l'une des revendications précédentes, comprenant en outre :
- un capteur (S), notamment raccordé électriquement à l'électronique de l'appareil, lequel capteur est destiné à générer au moins un signal de mesure dépendant d'une grandeur physique à mesurer ; et/ou
- un câble de raccordement (14) relié électriquement à l'électronique de l'appareil au moyen du dispositif de raccordement, lequel câble est notamment posé à l'extérieur du boîtier électronique et/ou comprend deux ou plusieurs conducteurs et/ou est relié électriquement à l'au moins une douille de contact de la deuxième partie de connecteur (20).

13. Procédé destiné au raccordement d'au moins un câble de raccordement électrique (14) à un appareil de terrain selon l'une des revendications précédentes, lequel procédé comprend les étapes suivantes :
- Raccordement électrique du câble de raccordement (14) à la deuxième partie de connecteur (20) ;
- Pivotement du volet de recouvrement dans la position d'ouverture pour relier la deuxième partie de connecteur (20) à la première partie de connecteur (19) ;
- Liaison de la deuxième partie de connecteur (20) à la première partie de connecteur (19), notamment de telle sorte que l'au moins une douille de contact (20') de la deuxième partie de connecteur (20) soit enfichée sur l'au moins une broche de contact (19') de la première partie de connecteur (19) ;
- Pivotement du volet de recouvrement dans la première position d'extrémité pour fixer la deuxième partie de connecteur (20) dans la première partie de connecteur (19) ; et
- Encliquetage de l'élément d'encliquetage (22) du volet de recouvrement (16) se trouvant dans la première position d'extrémité dans l'élément d'encliquetage (23) correspondant du corps de base (200) pour fixer le volet de recouvrement et/ou pour former une liaison par encliquetage entre le corps de base et le volet de recouvrement.
